# EUROPÄISCHE PATENTSCHRIFT

(11) **EP 2 992 548 B1**
(45) Veröffentlichungstag und Bekanntmachung des Hinweises auf die Patenterteilung: **22.04.2020**
(21) Anmeldenummer: 14722177.4
(22) Anmeldetag: 05.05.2014
(51) Int. Cl.: H01L 21/304, H01L 21/02

(54) **VERFAHREN ZUR HERSTELLUNG EINES WAFERS MIT TRÄGEREINHEIT**
METHOD FOR PRODUCING A WAFER WITH A SUPPORT UNIT
PROCÉDÉ DE FABRICATION D'UNE PLAQUETTE COMPORTANT UNE UNITÉ SUPPORT

(30) Priorität: 03.05.2013 DE 102013007671
(43) Veröffentlichungstag der Anmeldung: 09.03.2016
(73) Patentinhaber: Siltectra GmbH, 01099 Dresden (DE)
(72) Erfinder: LICHTENSTEIGER, Lukas, 8400 Winterthur (CH)
(74) Vertreter: Westphal, Mussgnug & Partner Patentanwälte mbB
(86) Internationale Anmeldenummer: PCT/EP2014/059101
(87) Internationale Veröffentlichungsnummer: WO 2014/177716

(56) Entgegenhaltungen:
- EP-A2- 1 858 087
- S. W. BEDELL ET AL: "(Invited) Cost-Effective Layer Transfer by Controlled Spalling Technology", ECS TRANSACTIONS, Bd. 50, Nr. 7, 15. März 2013 (2013-03-15), Seiten 315-323, XP055091846, ISSN: 1938-6737, DOI: 10.1149/05007.0315ecst
- STEPHEN W BEDELL ET AL: "Kerf-Less Removal of Si, Ge, and III V Layers by Controlled Spalling to Enable Low-Cost PV Technologies", IEEE JOURNAL OF PHOTOVOLTAICS, I E E E, US, Bd. 2, Nr. 2, 1. April 2012 (2012-04-01), Seiten 141-147, XP011434299, ISSN: 2156-3381, DOI: 10.1109/JPHOTOV.2012.2184267

## Beschreibung

Die vorliegende Erfindung bezieht sich gemäß den Patentansprüchen auf ein Verfahren zur Herstellung von Festkörperschichten, auf eine Vorrichtung zum Herstellen von Festkörperschichten, auf eine Trägereinheit zum Aufnehmen mindestens einer Festkörperschicht und auf einen entsprechend hergestellten Wafer.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafer für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hohes Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, was ein kontrolliertes Abspalten erschwert, und z.B. zu Dickenschwankungen des abgespaltenen Wafers führen kann. Außerdem erschwert die starke Krümmung die weitere Verarbeitung und kann sogar zum Zerbrechen des Wafers führen.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet bzw. führen die Dickenschwankungen aufgrund eines ungleichmäßigen Kontakts bei der Weiterverarbeitung des Wafers zu Problemen oder Wirkungsgradeinbußen. Außerdem liegen bei den am häufigsten auftretenden vierzähligen Dickenverteilungsmustern die Bereiche mit den größten Schwankungen unglücklicherweise in der Mitte des Wafers, wo sie am meisten stören.

Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können.

Zudem ist es bei den bisherigen Verfahren schwierig, einen reproduzierbar guten Wärmekontakt über die ganze Fläche der Polymerschicht sicherzustellen. Lokal ungenügender Wärmekontakt kann aber aufgrund der geringen thermischen Leitfähigkeit der verwendeten Polymere zu ungewollten, signifikanten lokalen Temperaturabweichungen im Schichtsystem führen, was sich seinerseits negativ auf die Kontrollierbarkeit der erzeugten Spannungsfelder und damit die Qualität der hergestellten Wafer auswirkt.

Schließlich besteht auch Bedarf für ein Verfahren, bei dem die beschichteten Werkstücke während des Abkühlvorgangs auf einfache Art mechanisch fixiert werden können (ggf. auch unter Ausübung von externen Kräften zur zusätzlichen Beeinflussung des Abspaltprozesses), und wo die Wafer nach dem Abspalten gut handhabbar sind. Nach aktuellem Stand der Technik zerbrechen viele der Wafer nach dem Abspalten, da die am Wafer anhaftende, relativ schwere Polymerschicht nach dem Aufwärmen weich wird und dadurch den spröden, dünnen Wafer nicht mehr genügend stützen kann.

Die Lehre der Patentveröffentlichung EP 1 858 087 A2 (IMEC INTER UNI MICRO ELECTR [BE]) 21. November 2007 (2007-11-21) ist ebenfalls relevanter Stand der Technik für die vorliegende Erfindung und bezieht sich auf das Abspalten eines dünnen Substrates von einem Muttersubstrat.

Es ist somit Aufgabe der vorliegenden Erfindung ein entsprechendes Verfahren, eine entsprechende Einrichtung und eine entsprechende Vorrichtung zur Herstellung von Festkörperschichten und/oder Festkörperplatten bereitzustellen, welche/s die Qualität der hergestellten Wafer gegenüber den bekannten Verfahren verbessert, insbesondere indem die Krümmung der abgespaltenen Wafer reduziert wird bzw. eine gleichmäßige Schichtdicke des Wafers erzeugt wird. Weitere Aufgaben der vorliegenden Erfindung sind die bei der Bruchpropagation entstehende unerwünschte Oszillationen zu vermindern, den Wärmekontakt zum Schichtsystem zu verbessern und zudem die Möglichkeit einer einfacheren und schonenderen Handhabbarkeit der Festkörperschichten und/oder -platten nach dem Abspalten zu ermöglichen. Weiterhin soll ein Wafer derart hergestellt werden, dass bei seiner Herstellung die zuvor genannten Nachteile überwunden werden.

Diese zuvor genannte Aufgabe wird durch ein Verfahren zur Herstellung von Festkörperschichten und/oder Platten, insbesondere zur Verwendung als Wafer, gemäß Anspruch 1 gelöst.

Das Verfahren weist dabei zumindest die folgenden Schritte auf: Bereitstellen eines Werkstücks zum Ablösen der Festkörperschichten, wobei das Werkstück zumindest eine exponierte Oberfläche aufweist, Erzeugen und/oder Bereitstellen einer Trägereinheit zum Aufnehmen mindestens einer Festkörperschicht, wobei die Trägereinheit mehrschichtig aufgebaut wird, wobei die Trägereinheit eine Stabilisierungsschicht aufweist und die Stabilisierungsschicht zumindest abschnittsweise durch eine Aufnahmeschicht überlagert wird, wobei die Aufnahmeschicht zum Halten der Festkörperschicht ausgebildet wird, und wobei die Stabilisierungsschicht zumindest abschnittsweise derart ausgebildet wird, dass sie einen E-Modul aufweist, der größer ist als der E-Modul der Aufnahmeschicht, und ein Verbinden der Aufnahmeschicht mit der exponierten Oberfläche des Werkstücks unter Bildung einer Kompositstruktur bzw. eines Laminats, sowie Beaufschlagen der Kompositstruktur mit einem inneren und/oder äußeren Spannungsfeld in der Art, dass die Festkörperschicht entlang einer sich innerhalb des Werkstücks erstreckenden Ebene von dem Werkstück abgelöst wird.

Weitere vorteilhafte Ausgestaltungen der Erfindung sind Gegenstand der Unteransprüche.

Gemäß einer bevorzugten Ausführungsform der vorliegenden Erfindung bestehen die Aufnahmeschicht und die Stabilisierungsschicht aus unterschiedlichen Materialien, wobei die Aufnahmeschicht bevorzugt ein Polymer, insbesondere Polydimethylsiloxane (PDMS), aufweist und die Stabilisierungsschicht bevorzugt ein Metall, insbesondere Aluminium, umfasst.

Die Aufnahmeschicht wird bevorzugt durch mindestens ein Polymer gebildet, wobei das mindestens eine Polymer bzw. das sich aus mehreren Werkstoffen ergebende Polymer bevorzugt aus einem oder mehreren Duroplasten und/oder aus einem oder mehreren Elastomeren und/oder aus einem oder mehreren Thermoplasten und/oder aus einem oder mehreren thermoplastischen Elastomeren bestehen oder zumindest teilweise gebildet wird. Das Polymer weist somit bevorzugt mindestens einen Kunststoff, insbesondere mindestens ein Elastomer, insbesondere mindestens ein Silicon, insbesondere mindestens ein RTV-Silicon und/oder mindestens ein HTV-Silicon, insbesondere mindestens ein Polydimethylsiloxan (PDMS) auf oder besteht bevorzugt aus mindestens einem Kunststoff, insbesondere mindestens einem Elastomer, insbesondere mindestens einem Silicon, insbesondere mindestens einem RTV-Silicon und/oder mindestens einem HTV-Silicon, insbesondere mindestens ein Polydimethylsiloxan (PDMS).Als Polymer kann somit besonders bevorzugt z.B. ein Polydiorganolsiloxan verwendet werden, z.B. Polydimethylsiloxane (PDMS). Im Folgenden wird als Polymerschicht bzw. Aufnahmeschicht bevorzugt eine Folie aus PDMS verwendet.

Mit der vorliegenden Erfindung, d.h. insbesondere durch die Verwendung von Polymer-Metall-Laminaten als Schichtsysteme zur Erzeugung thermisch induzierter mechanischer Spannungsfelder, werden alle zuvor genannten Probleme und Einschränkungen behoben. Als Werkstück wird in den hier beschriebenen Anwendungsbeispielen vorzugsweise ein dickerer Wafer verwendet, von welchem dann unter Verwendung des beschriebenen Verfahrens ein oder mehrere, dünnere Wafer abgespaltet werden.

Diese Ausführungsform ist vorteilhaft, da sie ermöglicht die Dickenschwankungen massiv zu reduzieren, indem statt der nach bisherigem Stand der Technik verwendeten reinen Polymerschichten Schichten aus geeignet konfigurierten Polymer-Metall-Laminaten eingesetzt werden. Diese Schichten bestehen z.B. aus abwechselnd einer Lage aus Polymer und einer Lage aus einem Metall, z.B. Aluminium, wobei die innerste, d.h., die der Waferoberfläche am nächsten liegende, mechanische Spannung erzeugende Schicht bevorzugt jeweils immer aus Polymer besteht. Mit den entsprechenden, im Folgenden beschriebenen erfindungsgemäßen Verfahren können Festkörperschichten, wie insbesondere Wafer, mit viel geringeren totalen Dickenschwankungen hergestellt werden (Wafer mit Dickenschwankungen < 40% der mittleren Waferdicke wurden so bereits experimentell verifiziert), wobei bzgl. räumlicher Dickenverteilung vorteilhaftere lineare Muster erzielt und insbesondere die Bereiche mit den größten Schwankungen eingestellt werden können, wie z.B. in die Nähe des Waferrandes gebracht werden können, wo sie weniger stören.

Bei Anwendungsbeispielen, wo die äußerste (d.h., die am weitesten von der Waferoberfläche entfernte) Schicht des Laminats bevorzugt aus Metall besteht, hat dies infolge der guten Wärmeleitfähigkeit von Metallen außerdem den Vorteil, dass über diese Schicht ein sehr guter thermischer Kontakt zum Laminat möglich ist, was eine effiziente, lokal gut kontrollierbare und reproduzierbare Kühlung des Laminats ermöglicht. Außerdem kann eine Metallschicht oder Metallplatte üblicherweise einfacher an einer Maschine befestigt werden als die verwendeten Polymerschichten, was die automatisierte (Weiter-) Verarbeitung der Wafer erleichtert. Zudem erlaubt eine solche Befestigung, dass mittels einer Maschine, z.B. während des Kühlprozesses, auch externe mechanische Kräfte kontrolliert auf den Verbund Laminat-Wafer ausgeübt werden können, womit der Abspaltprozess weiter beeinflusst werden kann. Insbesondere ist denkbar, dass die Dicke der hergestellten Wafer sowohl durch von außen ausgeübten Kräften wie auch durch die Steifigkeit (Elastizitätsmodul) der beteiligten Schichten beeinflusst werden kann, und alle diese Parameter sind bei der Verwendung der erfindungsgemäßen Laminate in großen Bereichen gut und weitgehend unabhängig voneinander kontrollierbar.

Als Polymer kann z.B. ein Polydiorganolsiloxan verwendet werden, z.B. Polydimethylsiloxane (PDMS). Im Folgenden wird als Polymerschicht bzw. als Aufnahmeschicht eine Folie aus PDMS und als Werkstück ein Wafer, insbesondere ein dicker Wafer, aus Silizium beschrieben; es können aber auch andere geeignete Polymere und Werkstücke (z.B. aus anderen Materialien, wie Galliumarsenid, Germanium, Galliumnitrid, Siliziumcarbid, Saphir, etc.) verwendet werden.

Der E-Modul des Materials der Stabilisierungsschicht ist gemäß einer weiteren bevorzugten Ausführungsform der vorliegenden Erfindung im Wesentlichen, genau oder mindestens doppelt so groß, wie der E-Modul des Materials der Aufnahmeschicht.

Diese Ausführungsform ist vorteilhaft, da so ein Laminat geschaffen wird, das Schichten (insbesondere die Stabilisierungsschicht/en), insbesondere aus Metall/en verwendet, welche ein wesentlich (mindestens, genau oder ca. eine oder zwei oder mehr Größenordnung/en) größeres Elastizitätsmodul als die Aufnahmeschicht/en, insbesondere das Polymer, haben, was zu gesamthaft wesentlich steiferen Schichten als bei der Verwendung von reinen Polymerschichten führt. Dadurch können unerwünschte Oszillationen während der Bruchpropagation gedämpft und die starke Krümmung des Wafers nach dem Abspalten reduziert werden, wodurch die Dickenschwankungen bei den hergestellten Wafern verringert werden. Da die innerste Schicht des Laminats zum Wafer hin weiterhin aus Polymer besteht, können die Vorteile des Polymers (z.B. sehr hoher thermischer Ausdehnungskoeffizient, sehr geringe Kontamination, etc.) trotzdem erfolgreich genutzt werden.

Gemäß einer weiteren Ausführungsform der vorliegenden Erfindung werden die Aufnahmeschicht und die Stabilisierungsschicht zur Ausbildung der Trägereinheit stoffschlüssig miteinander verbunden, insbesondere wird die Aufnahmeschicht als Folie und bevorzugt als vorgefertigte Folie erzeugt und an die Stabilisierungsschicht angeklebt.

Dies hat den Vorteil, dass die Fertigung und Qualifikation der Polymerschichten, insbesondere der Aufnahmeschicht/en und/oder einer oder mehrerer eventuellen Verbindungsschicht/en, unabhängig von der Festkörperschichtherstellung bzw. Waferfertigung geschehen kann. Mit anderen Worten: die Eigenschaften der einzelnen Polymerschichten können somit unabhängig von anderen Prozessschritten definiert und kontrolliert werden. Speziell können beispielsweise auch strukturierte Folien verwendet werden, wo z.B. die Foliendicke je nach Position gezielt variiert wird, so dass Polymerschichten mit definierten Dickenprofilen möglich sind.

Zur Herstellung der Polymerfolien ist bevorzugt PDMS verwendbar. Dies ist ein zweikomponentiges Gemisch, das thermisch ausgehärtet wird (z.B. Mischverhältnisse zwischen Härter: Basismaterial von bevorzugt 1:100 bis 1:1 und besonders bevorzugt von 1:30 bis 1:3). Zum Härten sind - je nach Härtezeit - Temperaturen von Raumtemperatur bis ca. 300°C und bevorzugt bis 200°C, vorzugsweise von Raumtemperatur bis ca. 120°C, vorsehbar. Bevorzugt sind Härtezeiten zwischen ca. 1-120 Minuten (bei hohen Temperaturen) und 1-6 Tagen (bei Raumtemperatur) vorsehbar. Bei PDMS handelt es sich vor dem Härten um eine viskose Flüssigkeit, die z.B. mittels Gießverfahren auf eine bevorzugt glatte Oberfläche (z.B. einen Spiegel) aufgebracht wird und dort zu einer Folie aushärtet. Die Folie wird von dieser Oberfläche dann abgezogen (z.B. mechanisch), gegebenenfalls weiterverarbeitet, und danach auf die zu beschichtende Oberfläche aufgebracht. Außerdem kann die fertige Folie bereits vor dem Aufbringen untersucht und ihre Qualität überprüft werden (z.B. mit üblichen mechanischen, optischen oder elektrischen Messverfahren, etc.). Neben dem hier beschriebenen Verfahren zur Folienherstellung sind viele andere Verfahren in der Industrie üblich (z.B. Herstellung durch Extrusion), welche ebenfalls für die vorliegende Erfindung anwendbar sind.

Die Aufnahmeschicht wird gemäß einer weiteren bevorzugten Ausführungsform der vorliegenden Erfindung mittels einer Klebeschicht, plasmaaktiviertem Kleben oder Auflaminieren mit der Stabilisierungsschicht verbunden.

Eine erste Folie bzw. Aufnahmeschicht wird somit nach ihrer Herstellung auf die Oberfläche einer ebenen Metallplatte bzw. Stabilisierungsschicht aufgeklebt. Im Folgenden wird als Metallplatte eine Platte aus Aluminium beschrieben; es können aber auch Platten aus anderen geeigneten Materialien (z.B. Messing, Stahl, Silizium etc.) verwendet werden. Dabei ist eine gute Haftung dieser ersten Folie auf der Metallplatte wichtig: die Verbindung zwischen Metallplatte und Folie muss genügend große Scherkräfte für das Abspalten sowie große Temperaturschwankungen für das thermische Induzieren der nötigen Spannungen aushalten können. Die Haftung kann z.B. durch mechanisches Aufrauen der Metalloberfläche, Eloxieren des Aluminiums, Ätzprozesse, etc. verbessert werden.

Für das Aufkleben der ersten Folie bzw. der Aufnahmeschicht bietet sich z.B. ein dünner PDMS-Film als Kleber an. Das PDMS wird in diesem Beispiel im flüssigen Zustand auf beide zu verklebenden Oberflächen dünn aufgetragen (einige Milliliter für einen 6-inch Wafer). Danach wird die Folie auf die Metallplatte aufgelegt und mit einer Rolle oder Walze unter leichtem Druck angepresst. Durch Hin- und Herbewegen der Rolle verteilt sich der Kleberfilm unter der Folie, Luftblasen werden entfernt. Die Aushärtung des Klebers kann z.B. bei Temperaturen zwischen Raumtemperatur und ca. 200°C erfolgen. Die Härtezeiten variieren, wie bei der Folienherstellung, abhängig von der Härtetemperatur (siehe oben). Alternativ zum beschriebenen Verfahren kann die Folie bzw. die Aufnahmeschicht auch mit anderen üblichen Verfahren auf die Metallplatte bzw. die Stabilisierungsschicht aufgeklebt werden, beispielsweise unter Verwendung eines Vakuum-Laminators.

Schließlich kann die Folie auch bevorzugt direkt (ohne Kleber) mit der Oberfläche der Metallplatte verbunden werden, z.B. mittels "Plasma activated bonding" (z.B. Aktivierung der PDMS-Folie in Stickstoffplasma, Aufpressen der Folie auf Metallplatte, ggf. "Annealing") oder z.B. durch Auflaminieren (Aufschmelzen) einer thermoplastischen Folie (z.B. Geniomer von Wacker Silicones).

Nach dem Aufkleben der Aufnahmeschicht bzw. der ersten Polymerfolie auf die Stabilisierungsschicht bzw. die Metallplatte und dem Aushärten des Klebers wird bevorzugt mit einem vorzugsweise analogen Verfahren das Werkstück (im vorliegenden Beispiel ein dicker Siliziumwafer) auf die Aufnahmeschicht bzw. die erste Polymerfolie geklebt.

Die Aufnahmeschicht ist gemäß einer weiteren bevorzugten Ausführungsform der vorliegenden Erfindung strukturiert. Diese Ausführungsform ist vorteilhaft, da dadurch auch speziell strukturierte Folien verwendet werden können, wobei z.B. die Foliendicke je nach Position gezielt variiert wird, so dass eine oder mehrere Polymerschicht/en mit definierten Dickenprofilen möglich sind, wodurch eine lokal definierbare Kontrolle der Dickenschwankungen des hergestellten Wafers möglich ist..

Gemäß einer weiteren bevorzugten Ausführungsform der vorliegenden Erfindung wird die Aufnahmeschicht durch die Aufbringung eines zumindest zeitweise fließfähigen Materials auf die Stabilisierungsschicht und eine Verfestigung, insbesondere Aushärtung, des Materials ausgebildet.

Im Rahmen einer Prozessalternative ist es bei diesem Anwendungsbeispiel auch möglich, eine oder mehrere der verwendeten Polymerschichten (Aufnahmeschicht/en und/oder Verbindungsschicht/en) nicht als vorgefertigte Folie aufzukleben, sondern direkt in situ herzustellen. Die Aufnahmeschicht bzw. erste Polymerschicht kann so beispielsweise wie folgt hergestellt werden: Eine vorgegebene Menge flüssiges PDMS wird auf die Stabilisierungsschicht, insbesondere eine Metallplatte, aufgetragen. Die Stabilisierungsschicht bzw. Metallplatte ist dabei horizontal ausgerichtet, so dass das PDMS infolge der Schwerkraft gleichmäßig bzw. im Wesentlichen gleichmäßig zerläuft und eine Schicht konstanter bzw. im Wesentlichen konstanter Dicke bildet. Ein Überfließen an den Rändern kann durch eine geeignete Schalungsvorrichtung oder z.B. durch die Oberflächenspannung des PDMS selbst verhindert werden. Zuletzt wird diese flüssige PDMS-Schicht direkt auf der Metallplatte gehärtet, ein separates Kleben entfällt dadurch.

Das Werkstück wird gemäß einer weiteren bevorzugten Ausführungsform der vorliegenden Erfindung vor der Verfestigung des Materials mit dem Material in Kontakt gebracht, wobei das Werkstück zumindest abschnittsweise in das Material eintaucht.

Gemäß diesem Ausführungsbeispiel kann somit auf vorteilhafte Weise vollständig auf das Kleben von vorgefertigten Polymerfolien verzichtet werden. Dabei wird, wie oben beschrieben, ein flüssiges Material, insbesondere ein flüssiges Polymer, wie vorzugsweise PDMS, direkt auf die Metallplatte aufgebracht, wobei diese bevorzugt horizontal ausgerichtet und an den Rändern bevorzugt mit einem geeigneten Abschluss (Schalung) versehen ist, welche besonders bevorzugt das Überfließen des PDMS verhindert. Dadurch entsteht eine Art Becken gefüllt mit flüssigem PDMS. Das Werkstück (der Wafer) wird bevorzugt allseitig mit einer dünnen Schicht flüssigem PDMS benetzt und dann in das Becken mit flüssigem Material, insbesondere ein PDMS-Becken, getaucht (die vorherige Benetzung mit PDMS reduziert die Bildung von Luftblasen an der Waferoberfläche). Durch die Schwerkraft sinkt das Werkstück bzw. der Wafer an den Boden des Beckens, wo er in geringem Abstand zur Oberfläche der Stabilisierungsschicht bzw. der Metallplatte zur Ruhe kommt.

Die Eintauchtiefe ist gemäß einer weiteren bevorzugten Ausführungsform der vorliegenden Erfindung einstellbar, insbesondere mittels einer Erhöhung der vom Werkstück auf die Trägereinheit ausgeübten Normalkraft oder durch die Einbringung von Abstandshaltern.

Diese Ausführungsform ist vorteilhaft, da die Distanz derart einstellbar ist, dass das Werkstück in geeigneter Weise über die Aufnahmeschicht mit der Stabilisierungsschicht koppelbar bzw. wirkverbindbar ist.

Die Distanz zwischen dem Werkstück bzw. Waferoberfläche und der Stabilisierungsschicht bzw. der Metallplatte ist bevorzugt durch das Gleichgewicht zwischen Schwerkraft / Auftrieb des Wafers und Oberflächenspannung des PDMS an der Wafer- und Metalloberfläche bestimmt. Diese Distanz kann durch künstliches Erhöhen der Schwerkraft (z.B. mittels einer Zentrifuge) verringert werden, oder kann durch Einpassen von vorzugsweise dünnen mechanischen Abstandshaltern, die vorzugsweise selbst aus einem Polymer und insbesondere PDMS bestehen können bzw. ein Polymer, insbesondere PDMS, aufweisen können, zwischen dem Werkstück bzw. dem Wafer und der Stabilisierungsschicht bzw. der Metallplatte vergrößert werden. Diese Distanz bestimmt bevorzugt die Dicke der ersten Polymerschicht (zwischen Metallplatte und Wafer), die Dicke der zweiten Polymerschicht (auf der gegenüberliegenden Seite des Wafers) wird bevorzugt durch die Menge an PDMS im Becken bestimmt. Das PDMS wird anschließend ausgehärtet, und danach werden, wie bezüglich einer vorher beschriebenen Ausführungsform bereits beschrieben, bevorzugt die seitlichen Ränder der Polymerschichten in einem definierten Abstand zum Werkstückrand bzw. Waferrand getrimmt, beispielsweise bündig zum Werkstückrand bzw. Waferrand.

In einem der Ausführungsbeispiele kann das Laminat alternativ oder zusätzlich durch Verkleben von vorgefertigten Metall- und Polymerschichten bzw. Stabilisierungs- und Aufnahmeschichten hergestellt werden. Nach dem Aufkleben der ersten Polymerfolie auf die Metallplatte und Aushärten des Klebers wird mit einem analogen Verfahren das Werkstück (im vorliegenden Beispiel ein dicker Siliziumwafer) auf die erste Polymerfolie geklebt, und danach - wieder mit einem analogen Verfahren - eine zweite, im Allgemeinen bzw. im Wesentlichen dickere Polymerfolie, auf die noch freie Seite des Wafers geklebt. Zum Schluss werden im vorliegenden Beispiel die seitlichen Ränder aller Polymerfolien getrimmt, so dass sie mit dem Waferrand bündig abschließen.

In einem weiteren Beispiel kann die Aufnahmeschicht jeweils direkt zwischen die Stabilisierungsschicht bzw. Metallschicht und das Werkstück bzw. den Wafer gegossen werden, so dass kein spezieller Klebeschritt benötigt wird.

Gemäß einer weiteren bevorzugten Ausführungsform der vorliegenden Erfindung wird eine Verbindungsschicht, insbesondere ein Polymer und bevorzugt Polydimethylsiloxane (PDMS), aufweisend, auf das Werkstück aufgebracht, wobei die Verbindungsschicht im Wesentlichen parallel zur Aufnahmeschicht angeordnet ist und die im Wesentlichen zueinander parallelen Anteile der Verbindungsschicht und der Aufnahmeschicht durch das sich dazwischen erstreckende Werkstück voneinander beabstandet sind. Diese Ausführungsform ist vorteilhaft, da mittels der Verbindungsschicht mindestens eine weitere Schicht, insbesondere aus Werkstoff bzw. Silizium oder eine Stabilisierungsschicht, anordenbar ist.

Die zuvor beschriebenen Ausführungsbeispiele verwenden bevorzugt ein asymmetrisches Schichtsystem bestehend aus Metall-Polymer-Wafer-Polymer, wobei die Polymerschicht (d.h. die Aufnahmeschicht) zwischen Metall und Wafer wesentlich dünner ist als diejenige Polymerschicht (d.h. die Verbindungsschicht) auf der gegenüberliegenden Seite des Wafers. Selbstverständlich kann das vorliegende Verfahren aber auch mit anderen Schichtsystemen angewandt werden, insbesondere symmetrische Schichtsysteme bestehend aus Metall-Polymer-Wafer-Polymer-Metall sowie Metall-Polymer-Wafer-Polymer-Wafer-Polymer-Metall sind bereits erfolgreich getestet worden.

Bevorzugt gilt unabhängig vom jeweiligen Ausführungsbeispiel bzw. der jeweiligen Ausführungsform, dass die benötigten Dicken und Materialeigenschaften (insbesondere Elastizitätsmodule) der verwendeten Aufnahmeschicht/en, insbesondere Polymerschicht/en, sowie der Stabilisierungsschicht/en, insbesondere der Metallplatte/n, von den Dicken und Materialeigenschaften des Werkstücks abhängen sowie der gewünschten Zieldicke der abzuspaltenden Festkörperschicht, insbesondere des Wafers, abhängen. Bei den hier beschriebenen Anwendungsbeispielen wird ein 400 Mikrometer dicker, monokristalliner, pseudoquadratischer 6-inch Siliziumwafer mit <100> Orientierung hälftig in zwei 200 Mikrometer dicke Wafer gespalten. Die dazu verwendeten Schichten im Laminat haben bevorzugt die folgenden Dicken: Die Stabilisierungsschicht, insbesondere als Metallplatte ausgeführt, besteht bevorzugt aus Aluminium bzw. weist besonders bevorzugt Aluminium auf und ist bevorzugt zwischen 0,1 und 10 mm, insbesondere zwischen 0.5 und 5 mm dick, die Aufnahmeschicht, insbesondere eine erste Polymerschicht (zwischen Metallplatte und Werkstück), ist bevorzugt zwischen 0,01 und 2 mm, insbesondere zwischen 0.02 und 1 mm dick, eine Verbindungsschicht, insbesondere eine zweite Polymerschicht, ist bevorzugt zwischen 0,1 und 20 mm, insbesondere zwischen 0.2 und 10 mm dick. Die seitlichen Abmessungen der Polymerschichten entsprechen bevorzugt jeweils denen des Wafers, wobei die Ränder besonders bevorzugt bündig mit dem Waferrand übereinander liegen. Die seitlichen Abmessungen der Metallplatte sind bevorzugt etwas grösser, so dass diese relativ zum Waferrand gesehen z.B. jeweils ca. 1 cm vorsteht.

Nachdem das Laminat Metallplatte-Polymerschicht-Werkstück-Polymerschicht z.B. unter Verwendung eines der vorher beschriebenen Ausführungsbeispiele hergestellt und das Polymer ausgehärtet ist, wird, wie in den im Stand der Technik beschriebenen Referenzen üblich, z.B. durch thermisch induzierte Spannungen ein dünner Wafer vom Werkstück abgelöst, wobei ein Teil des Laminats (in den beschriebenen Beispielen die zweite Polymerschicht bzw. die Verbindungsschicht) noch auf einer Seite des Werkstücks bzw. Wafers anhaftet. Dieser Laminatteil kann dann vom hergestellten Wafer z.B. mit mechanischen oder chemischen Methoden abgelöst werden, wie in den erwähnten Referenzen dargestellt. Am verbleibenden Rest des Werkstücks haftet entsprechend auf einer Seite noch der andere Teil des Laminats (in den beschriebenen Beispielen die erste Polymerschicht bzw. die Aufnahmeschicht und daran die Metallplatte bzw. die Stabilisierungsschicht). Auch dieser kann z.B. mit mechanischen oder chemischen Methoden abgelöst werden, wie ebenfalls in den erwähnten Referenzen dargestellt. Um das Ablösen der Laminate nach dem Abspalten des Wafers zu erleichtern, kann es zudem hilfreich sein, das Laminat leicht zu krümmen, was insbesondere dank der verbundenen Metallplatte einfach und kontrolliert möglich ist.

Die Verbindungsschicht verbindet gemäß einer weiteren bevorzugten Ausführungsform der vorliegenden Erfindung ein weiteres Werkstück oder eine weitere Stabilisierungsschicht mit dem Werkstück, wobei die Verbindungsschicht eine Dicke im Bereich von 0,1 mm und 20 mm, insbesondere in einem Bereich von 0,2 mm und 10 mm, und die Stabilisierungsschicht eine Dicke im Bereich von 0,01 mm und 2 mm, insbesondere im Bereich von 0,02 mm und 1 mm, aufweist.

Diese Ausführungsform ist vorteilhaft, da das Werkstück von mehreren, insbesondere zwei, Seiten mit Kräften beaufschlagbar ist.

Weiterhin ist das Laminat bevorzugt wiederverwendbar. Nachdem das Laminat (mit oder ohne verbundene Metallplatte) vom hergestellten Werkstück bzw. Wafer abgelöst ist, kann es - falls gewünscht - gereinigt und danach auf ein neues Werkstück aufgebracht werden. Dadurch ist es möglich auf vorteilhafte Weise, dasselbe Laminat (mit oder ohne verbundene Metallplatte) mehrfach zur Herstellung von Wafer zu verwenden. Dies kann den Materialverbrauch und die Kosten des Gesamtprozesses signifikant reduzieren. Für eine Wiederverwendung des Laminats ist es insbesondere vorteilhaft, zur Befestigung des Werkstücks einen wieder auflösbaren Kleber zu verwenden, da in diesem Fall nach dem Auflösen der Kleberschicht am Laminat keine Kleberrückstände mehr verbleiben.

In den beschriebenen Ausführungsbeispielen wurde dargestellt, wie Schichtsysteme in Form von Laminaten von Polymerschichten und Schichten von anderen Materialien (insbesondere Materialien mit größerem Elastizitätsmodul als die verwendeten Polymere, also insbesondere Metalle) zur Lösung der eingangs erwähnten Probleme bei der Herstellung von Wafern verwendet werden können. Um entsprechende Schichtsysteme, die aus Schichten mit jeweils unterschiedlichen Elastizitätsmodulen bestehen, zu erzeugen, müssen aber nicht unbedingt unterschiedliche Materialien kombiniert werden: Es ist z.B. auch möglich, durch unterschiedliche Bearbeitung des verwendeten Polymers (insbesondere unterschiedliche Härtung) Polymerschichten mit unterschiedlichen Elastizitätsmodulen herzustellen. Außerdem hängt das Elastizitätsmodul des verwendeten Polymers stark von der Temperatur ab (mit einem ausgeprägten Glasübergang bei ca. -125°C, wo das Elastizitätsmodul um mehrere Größenordnungen ansteigt). Es ist deshalb auch möglich, durch gezieltes Erzeugen von Bereichen / Schichten unterschiedlicher Temperatur im Polymer entsprechende Bereiche / Schichten mit unterschiedlichem Elastizitätsmodul zu erzeugen. Auch andere physikalische Größen als die Temperatur können u.U. lokal das Elastizitätsmodul einer entsprechenden Polymerschicht beeinflussen und können dann zur gezielten Erzeugung von Bereichen / Schichten mit unterschiedlichem Elastizitätsmodul verwendet werden.

Außerdem müssen die Schichten mit unterschiedlichem Elastizitätsmodul nicht notwendigerweise die ganze Fläche des Werkstücks abdecken, sondern es können je nach Anwendungsbeispiel auch Konfigurationen sinnvoll sein, wo z.B. nur eine kleinere Fläche (z.B. in der Mitte des Wafers) durch eine Schicht mit höherem Elastizitätsmodul abgedeckt wird. Auch eine als schmaler Streifen ausgestaltete Schicht kann sinnvoll sein, um übermäßige Krümmung und Oszillationen beim Abspalten zu unterdrücken und so die Dickenschwankungen der hergestellten Wafer zu reduzieren.

Eine weitere präferierte Realisierung der vorliegenden Erfindung besteht insbesondere darin, Laminate nach einem der hier beschriebenen Verfahren auf beiden gegenüberliegenden Seiten eines dicken Wafers aufzukleben. Dadurch kann der dicke Wafer in zumindest oder genau zwei dünne Wafer aufgespalten werden.

Gemäß einer weiteren bevorzugten Ausführungsform der vorliegenden Erfindung weist die Aufnahmeschicht bevorzugt ein Polymer auf bzw. besteht zumindest teilweise und besonders bevorzugt vollständig aus einem Polymer, wobei beim Beaufschlagen der Kompositstruktur, die bevorzugt zumindest aus der Aufnahmeschicht und dem Werkstück besteht, mit einem inneren und/oder äußeren Spannungsfeld mindestens ein Teil und bevorzugt mehrere Teile des Polymers, insbesondere PDMS, durch genau einen Glasübergang, mindestens einen Glasübergang oder mehrere, insbesondere zeitliche versetzte, Glasübergänge gehen. Es ist hierbei denkbar, dass das Initiieren des Glasübergangs infolge z.B. mechanischer und/oder chemischer und/oder thermischer und/oder akustischer Effekte bzw. Beaufschlagungen bewirkt wird.

Ferner bezieht sich die Erfindung auf eine Vorrichtung zum Herstellen von Festkörperschichten, insbesondere von Wafern. Die erfindungsgemäße Vorrichtung umfasst mindestens eine Beaufschlagungseinrichtung zum Beaufschlagen eines Werkstücks mit Spannungen zum Abspalten einer Festkörperschicht und eine Trägereinheit zum Aufnehmen mindestens einer Festkörperschicht, wobei die Trägereinheit eine Stabilisierungsschicht aufweist und die Stabilisierungsschicht zumindest abschnittsweise durch eine Aufnahmeschicht überlagert ist, wobei die Aufnahmeschicht zum Halten der Festkörperschicht ausgebildet ist, und wobei die Stabilisierungsschicht zumindest abschnittsweise derart ausgebildet ist, dass sie einen E-Modul aufweist, der größer ist als der E-Modul der Aufnahmeschicht.

Weiterhin bezieht sich die vorliegende Erfindung auf eine Trägereinheit zum Aufnehmen mindestens einer Festkörperschicht, wobei die Trägereinheit eine Stabilisierungsschicht aufweist und die Stabilisierungsschicht zumindest abschnittsweise durch eine Aufnahmeschicht überlagert ist, wobei die Aufnahmeschicht zum Halten der Festkörperschicht ausgebildet ist, und wobei die Stabilisierungsschicht zumindest abschnittsweise derart ausgebildet ist, dass sie einen E-Modul aufweist, der größer ist als der E-Modul der Aufnahmeschicht.

Die Verwendung der Wörter "im Wesentlichen" definiert bevorzugt in allen Fällen, in denen diese Wörter im Rahmen der vorliegenden Erfindung verwendet werden eine Abweichung im Bereich von 1%-30%, insbesondere von 1%-20%, insbesondere von 1%-10%, insbesondere von 1%-5%, insbesondere von 1%-2%, von der Festlegung, die ohne die Verwendung dieser Wörter gegeben wäre.

Weitere Vorteile, Ziele und Eigenschaften der vorliegenden Erfindung werden anhand nachfolgender Beschreibung anliegender Zeichnungen erläutert, in welchen beispielhaft erfindungsgemäße Wafer, Trägereinheiten und Vorrichtungen dargestellt sind. Bauteile oder Elemente der erfindungsgemäßen Wafer, Trägereinheiten und Vorrichtungen, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Einzelne oder alle Darstellungen der im Nachfolgenden beschriebenen Figuren sind bevorzugt als Konstruktionszeichnungen anzusehen, d.h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts.

Darin zeigt:
- Fig. 1a: eine erste schematische Darstellung einer Schichtanordnung gemäß dem Gegenstand der vorliegenden Erfindung;
- Fig. 1b: eine zweite schematische Darstellung einer Schichtanordnung gemäß dem Gegenstand der vorliegenden Erfindung;
- Fig. 1c: eine dritte schematische Darstellung einer Schichtanordnung gemäß dem Gegenstand der vorliegenden Erfindung;
- Fig. 1d: eine erste schematische Darstellung der Erzeugung einer Aufnahmeschicht auf einer Stabilisierungsschicht;
- Fig. 1e: eine zweite schematische Darstellung der Erzeugung einer Aufnahmeschicht auf einer Stabilisierungsschicht; und
- Fig. 2: eine schematische Darstellung eines bevorzugten Ablaufs des erfindungsgemäßen Herstellungsverfahrens.

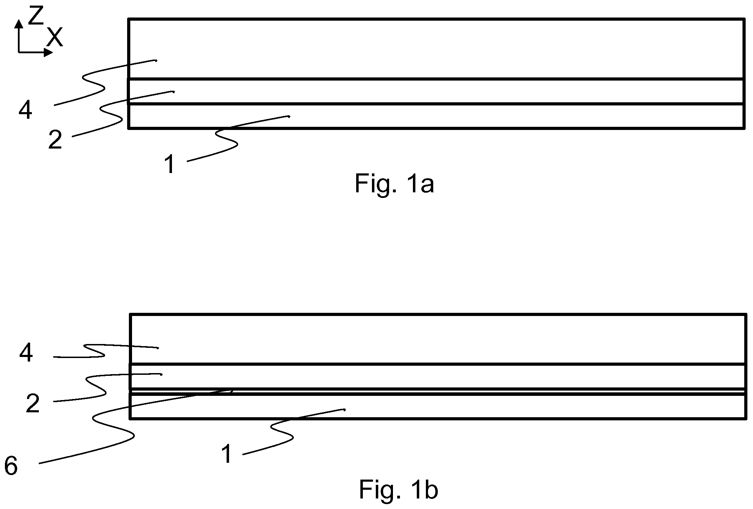

In Fig. 1a ist eine erste schematische Querschnittsdarstellung des erfindungsgemäßen Schichtaufbaus dargestellt. Der Schichtaufbau weist gemäß dieser Darstellung zumindest eine Stabilisierungsschicht 1, eine darüber bzw. daran bzw. darauf angeordnete Aufnahmeschicht 2 und ein darüber bzw. daran bzw. darauf angeordnetes Werkstück 4 auf.

Die einzelnen Schichten 1, 2, 4 können sich dabei in X, Y und Z Richtung gleich weit erstrecken, wobei auch denkbar ist, dass sich nur einzelne dieser Schichten in eine oder mehrere Richtungen gleich weit erstrecken. Bevorzugt erstrecken sich die einzelnen Schichten 1, 2, 4 zumindest in Z-Richtung jeweils unterschiedlich weit.

In Fig. 1b ist der in Fig. 1a gezeigte Schichtaufbau durch eine Klebeschicht 6, die zwischen der Stabilisierungsschicht 1 und der Aufnahmeschicht 2 ausgebildet ist, ergänzt. Die Klebeschicht 6 kann dazu verwendet werden die Stabilisierungsschicht 1 mit der Aufnahmeschicht 2 zu verbinden. Es sind jedoch Ausführungsformen denkbar, in denen auf eine Klebeschicht 6 verzichtet werden kann.

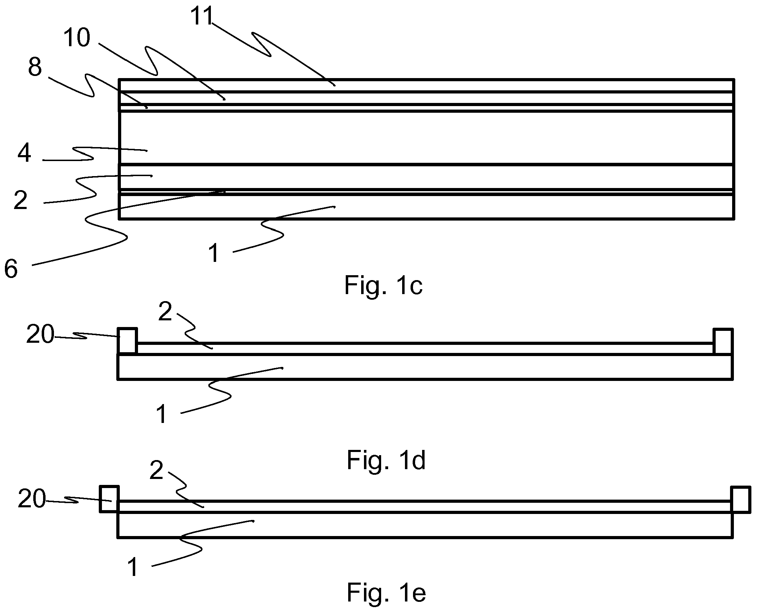

In Fig. 1c ist der in Fig. 1b gezeigte Schichtaufbau durch eine Verbindungsschicht 8, eine weitere Aufnahmeschicht 10 und eine weitere Schicht 11 ergänzt. Die Verbindungsschicht 8 wirkt dabei bevorzugt wie die Klebeschicht 6 und verbindet die weitere Aufnahmeschicht 10 mit dem Werkstück 4. Mit der weiteren Aufnahmeschicht 10 ist weiterhin bevorzugt eine weitere Schicht 11 verbunden, die besonders bevorzugt als weiteres Werkstück 4 oder als weitere Stabilisierungsschicht, insbesondere in Form einer Metallschicht, ausgebildet sein kann.

Ferner ist denkbar, dass zwischen der weiteren Aufnahmeschicht 10 und der weiteren Schicht 11 eine weitere Klebeschicht vorgesehen ist. Ebenso ist vorstellbar, dass die Verbindungsschicht 8 nur optional vorhanden ist.

In Fig. 1d ist eine Stabilisierungsschicht 1 gezeigt, auf der eine Fassung 20 angeordnet ist. Die Fassung 20 erstreckt sich bevorzugt vollständig in Umfangsrichtung der Stabilisierungsschicht 1 und ist besonders bevorzugt mit der Stabilisierungsschicht 1 in Kontakt bringbar. Gemäß der Darstellung Fig. 1d ist der Innendurchmesser der Fassung 20 kleiner als der Außendurchmesser der Stabilisierungsschicht 1. Der durch die Fassung 20 und die Stabilisierungsschicht 1 begrenzte Innenraum dient zur Aufnahme von fließfähigem, insbesondere flüssigem, Material. Das Material erstarrt nach dem zuführen in den Innenraum unter Ausbildung einer im Wesentlichen oder genau ebenen Schicht, insbesondere der Aufnahmeschicht 2.

Gemäß der Fig. 1e ist Fassung 20 größer als in der in Fig. 1d gezeigten Ausführungsform, wodurch die auf der Stabilisierungsschicht 1 erzeugte Aufnahmeschicht 2 bevorzugt im Wesentlichen und besonders bevorzugt vollständig die sich in der X-/Y-Ebene erstreckende Oberfläche der Stabilisierungsschicht 1 überlagert.

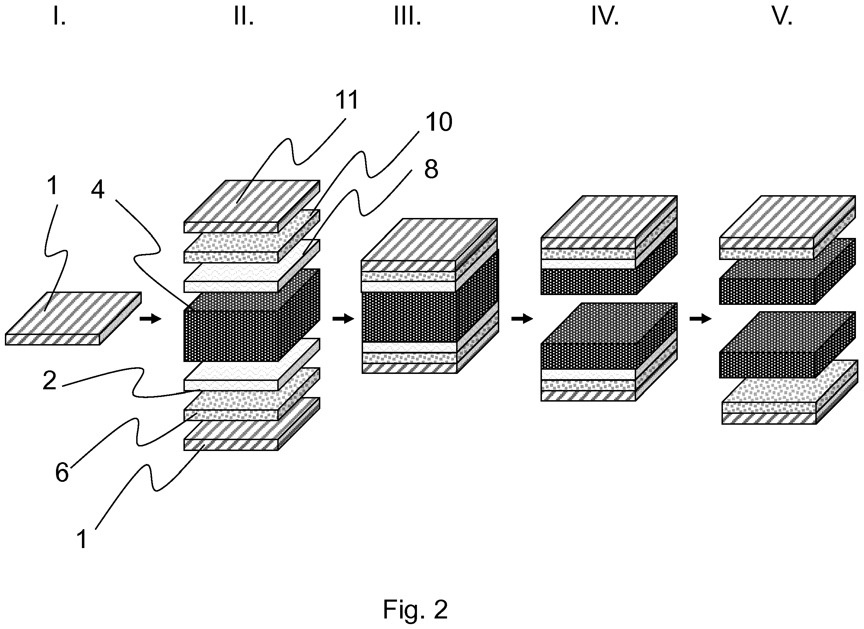

In Fig. 2 ist schematisch die Erzeugung einzelner Festkörperschichten aus einem Werkstück in Form eines Siliziumwafers gezeigt. Dabei erfolgt in einem ersten Schritt I die Bereitstellung einer ersten Schicht, insbesondere der Stabilisierungsschicht 1, welche aus Metall und insbesondere aus Aluminium aufgebaut ist. Weiterhin ist denkbar, dass weitere Schichten 2, 4 ebenfalls in diesem Schritt bereit gestellt werden.

In dem zweiten Schritt II werden weitere, bisher noch nicht bereitgestellte Schichten erzeugt und/oder mit einander verbunden. Bevorzugt werden die einzelnen Schichten wie dargestellt angeordnet. D.h., dass auf die Stabilisierungsschicht 1 bevorzugt eine Klebeschicht 6 (beispielsweise aus PDMS) aufgebracht wird, um eine Aufnahmeschicht 2 aus PDMS mit der Stabilisierungsschicht 1 zu koppeln bzw. zu verbinden. Die Aufnahmeschicht 2 steht bevorzugt direkt mit einem Werkstück 4 in Kontakt, wobei ebenfalls denkbar ist, dass eine Opferschicht bzw. eine weitere Klebeschicht zwischen der Aufnahmeschicht 2 und dem Werkstück 4 vorsehbar ist.

Der zuvor beschriebene Aufbau mit den Schichten 1, 6, und 2 auf dem Werkstück 4 kann an der anderen Seite des Werkstücks 4 analog aufgebracht werden oder alternativ in veränderter Form aufgebracht werden, wie im Folgenden erläutert ist. Parallel zur Aufnahmeschicht 2 und bevorzugt ebenfalls mit dem Werkstück 4 kontaktierend ist eine Verbindungsschicht 8 insbesondere in Form eines Klebers vorgesehen. Die Verbindungsschicht 8 kann zum Verbinden einer weiteren Aufnahmeschicht 10 aus PDMS und/oder einer weiteren Schicht 11 mit dem Werkstück 4 ausgebildet sein. Die weitere Schicht 11 ist dabei bevorzugt ebenfalls als Stabilisierungsschicht aus Metall oder als ein weiteres Werkstück ausgebildet, wobei an dem weiteren Werkstück wiederum ein entsprechender Schichtaufbau aus den Schichten 1, 6, 2 oder den Schichten 8, 10, 11 vorgesehen sein kann. Die Stabilisierungsschichten 1 sind bevorzugt steif bzw. bestehen aus steifen Materialien und ermöglichen eine mechanische Kopplung mit einer weiteren Einrichtung zur Spannungsbeaufschlagung. Der E-Modul der Stabilisierungsschicht 1 bzw. der Stabilisierungsschichten 1, 11 ist daher höher als der E-Modul der Aufnahmeschichten 2, 10. Zusätzlich oder alternativ ermöglichen die Stabilisierungsschichten 1 eine definierte lokale thermische Beaufschlagung des Werkstücks.

In dem Schritt III werden alle Schichten miteinander verbunden bzw. sind miteinander verbunden.

Im Schritt IV ist das Werkstück 4 in zwei Teile aufgespalten dargestellt, wobei ein Teil davon mit der Schichtanordnung 1, 6, 2 verbunden ist und der andere Teil mit der Schichtanordnung 8, 10, 11 verbunden ist. Beim Übergang vom Schritt III zum Schritt IV werden insbesondere lokal definierbare Spannungen in dem Werkstück 4 erzeugt, durch die das Werkstück 4 in mehrere, insbesondere genau zwei Teile bzw. Festkörperschichten aufgespalten wird. Bevorzugt erfolgt durch die Aufbringung von Kräften auf steiferen Stabilisierungsschicht/en 1, 11 eine mechanische Spannungsinduzierung in den Schichtaufbau. Die Spannungsinduzierung erfolgt aufgrund der beschriebenen Schichtanordnung mit Schichten 1, 6, 2 oder 8, 10, 11 unterschiedlicher E-Modulen äußerst vorteilhaft, da die Schichten mit geringeren E-Modulen beschädigungsfrei am Werkstück 4 anliegen können und die Schichten 1, 11 mit höheren E-Modulen mit weiteren Einrichtungen zur Kraftbeaufschlagung koppelbar sind.

Im optionalen Schritt V werden die einzelnen Festkörperschichten, die aus dem Werkstück 4 gewonnen wurden, wieder von den weiteren Schichten gelöst.

### Bezugszeichenliste

- 1.: Stabilisierungsschicht
- 2.: Aufnahmeschicht
- 4.: Werkstück
- 6.: Klebeschicht
- 8.: Verbindungsschicht
- 10.: Weitere Aufnahmeschicht
- 11.: Weitere Schicht
- 20.: Fassung
- X: Breite
- Y: Länge
- Z: Dicke

## Patentansprüche

1. Verfahren zur Herstellung von Festkörperschichten, insbesondere zur Verwendung als Wafer, mit den folgenden Schritten:
Bereitstellen eines Werkstücks (4) zum Ablösen der Festkörperschichten,
wobei das Werkstück (4) zumindest eine exponierte Oberfläche aufweist,
Erzeugen und/oder Bereitstellen einer Trägereinheit zum Aufnehmen mindestens einer Festkörperschicht,
wobei die Trägereinheit mehrschichtig aufgebaut wird,
wobei die Trägereinheit eine Stabilisierungsschicht (1) aufweist und die Stabilisierungsschicht (1) zumindest abschnittsweise durch eine Aufnahmeschicht (2) überlagert wird,
wobei die Aufnahmeschicht (2) zum Halten der Festkörperschicht ausgebildet wird,
und wobei die Stabilisierüngsschicht (1) zumindest abschnittsweise derart ausgebildet wird, dass sie einen E-Modul aufweist, der größer ist als der E-Modul der Aufnahmeschicht (2),
Verbinden der Aufnahmeschicht (2) mit der exponierten Oberfläche des Werkstücks (4) unter Bildung einer Kompositstruktur,
Beaufschlagen der Kompositstruktur mit einem inneren und/oder äußeren Spannungsfeld in der Art, dass die Festkörperschicht entlang einer sich innerhalb des Werkstücks (4) erstreckenden Ebene von dem Werkstück (4) abgelöst wird.

2. Verfahren nach Anspruch 1,
**dadurch gekennzeichnet, dass**
die Aufnahmeschicht (2) und die Stabilisierungsschicht (1) aus unterschiedlichen Materialien bestehen,
wobei die Aufnahmeschicht (2) bevorzugt ein Polymer, insbesondere Polydimethylsiloxane (PDMS), aufweist und die Stabilisierungsschicht (1) bevorzugt ein Metall aufweist.

3. Verfahren nach Anspruch 2,
**dadurch gekennzeichnet, dass**
der E-Modul des Materials der Stabilisierungsschicht (1) mindestens doppelt so groß ist, wie der E-Modul des Materials der Aufnahmeschicht (2).

4. Verfahren nach einem der vorangegangenen Ansprüche,
**dadurch gekennzeichnet, dass**
die Aufnahmeschicht (2) und die Stabilisierungsschicht (1) stoffschlüssig miteinander verbunden werden.

5. Verfahren nach einem der vorangegangenen Ansprüche,
**dadurch gekennzeichnet, dass**
die Aufnahmeschicht (2) als Folie erzeugt wird und die Aufnahmeschicht (2) zur Ausbildung der Trägereinheit mit der Stabilisierungsschicht (1) verbunden wird.

6. Verfahren nach Anspruch 5,
**dadurch gekennzeichnet, dass**
die Aufnahmeschicht (2) mittels einer Klebeschicht (6), insbesondere Polydimethylsiloxane (PDMS) aufweisend, plasmaaktiviertem Kleben oder Auflaminieren mit der Stabilisierungsschicht verbunden wird.

7. Verfahren nach Anspruch 5 oder Anspruch 6,
**dadurch gekennzeichnet, dass**
die Aufnahmeschicht (2) derart oberflächenstrukturiert ist, dass infolge der Oberflächenstrukturierung lokal definierbare Spannungen in dem Werkstück erzeugt werden.

8. Verfahren nach einem der Ansprüche 1 bis 4
**dadurch gekennzeichnet, dass**
die Aufnahmeschicht (2) durch die Aufbringung eines zumindest zeitweise fließfähigen Materials auf die Stabilisierungsschicht (1) und eine Verfestigung des Materials ausgebildet wird.

9. Verfahren nach Anspruch 8,
**dadurch gekennzeichnet, dass**
das Werkstück (4) vor der Verfestigung des Materials mit dem Material in Kontakt gebracht wird, wobei das Werkstück (4) zumindest abschnittsweise in das Material eintaucht.

10. Verfahren nach Anspruch 9,
**dadurch gekennzeichnet, dass**
die Eintauchtiefe einstellbar ist, insbesondere mittels einer Erhöhung der vom Werkstück (4) auf die Trägereinheit ausgeübten Normalkraft oder durch die Einbringung von Abstandshaltern.

11. Verfahren nach einem der vorangegangenen Ansprüche,
**dadurch gekennzeichnet, dass**
eine Verbindungsschicht (8), insbesondere ein Polymer bevorzugt Polydimethylsiloxane (PDMS) aufweisend, auf das Werkstück (4) aufgebracht wird, wobei die Verbindungsschicht (8) im Wesentlichen parallel zur Aufnahmeschicht (2) angeordnet ist und die im Wesentlichen zueinander parallelen Anteile der Verbindungsschicht (8) und der Aufnahmeschicht (2) durch das sich dazwischen erstreckende Werkstück (4) voneinander beabstandet sind.

12. Verfahren nach Anspruch 11,
**dadurch gekennzeichnet, dass**
die Verbindungsschicht (8) ein weiteres Werkstück (4) oder eine weitere Stabilisierungsschicht mit dem Werkstück (11) verbindet, wobei die Verbindungsschicht (8) eine Dicke im Bereich von 0,1 mm und 20 mm, insbesondere in einem Bereich von 0,2 mm und 10 mm, und die Stabilisierungsschicht (1) eine Dicke im Bereich von 0,01 mm und 2 mm, insbesondere im Bereich von 0,02 mm und 1 mm, aufweist.

13. Verfahren nach einem der vorangegangenen Ansprüche,
**dadurch gekennzeichnet, dass**
die Aufnahmeschicht ein Polymer aufweist, wobei beim Beaufschlagen der Kompositstruktur aus Aufnahmeschicht und Werkstück mit einem inneren und/oder äußeren Spannungsfeld mindestens ein Teil des Polymers durch mindestens einen Glasübergang geht.

14. Vorrichtung zum Herstellen von Festkörperschichten, insbesondere von Wafern, mindestens umfassend
eine Beaufschlagungseinrichtung zum Beaufschlagen eines Werkstücks (4) mit Spannungen zum Abspalten einer Festkörperschicht und
eine Trägereinheit wobei die Trägereinheit eine Stabilisierungsschicht (1) aufweist und die Stabilisierungsschicht (1) zumindest abschnittsweise durch eine Aufnahmeschicht (2) überlagert ist, wobei die Aufnahmeschicht (2) zum Halten der Festkörperschicht ausgebildet ist, **dadurch gekennzeichnet, dass** die Stabilisierungsschicht (1) zumindest abschnittsweise derart ausgebildet ist, dass sie einen E-Modul aufweist, der größer ist als der E-Modul der Aufnahmeschicht (2).

15. Trägereinheit zum Aufnehmen mindestens einer Festkörperschicht, insbesondere zur Verwendung in einer Vorrichtung gemäß Anspruch 14,
wobei die Trägereinheit eine Stabilisierungsschicht (1) aufweist und
die Stabilisierungsschicht (1) zumindest abschnittsweise durch eine Aufnahmeschicht (2) überlagert ist, wobei die Aufnahmeschicht (2) zum Halten der Festkörperschicht ausgebildet ist, und wobei die Stabilisierungsschicht (1) zumindest abschnittsweise derart ausgebildet ist, dass sie einen E-Modul aufweist, der größer ist als der E-Modul der Aufnahmeschicht (2).

## Claims

1. A method for producing layers of solid material, in particular for use as wafers, comprising:
providing a workpiece (4) for separating the layers of solid material, wherein the workpiece (4) comprises at least one exposed surface,
producing and/or providing a carrier unit for receiving at least one layer of solid material,
the carrier unit having a multi-layer structure,
the carrier unit having a stabilization layer (1) and the stabilization layer (1) being overlapped at least in portions by a receiving layer (2),
the receiving layer (2) being made to hold the layers of solid material,
and the stabilization layer (1) being formed, at least in portions, to have a Young's modulus greater than a Young's modulus of the receiving layer (2);
connecting the receiving layer (2) to the exposed surface of the workpiece (4) to form a composite structure,
exposing the composite structure to an inner and/or outer stress field such that the layer of solid material is separated from the workpiece (4) along a plane extending within the workpiece (4).

2. The method of claim 1,
**characterized in that**
the receiving layer (2) and the stabilization layer (1) are made of different materials, wherein the receiving laxer (1) preferably comprises a polymer, in particular a polydimethylsiloxane (PDMS), and the stabilization layer (1) preferably comprises a metal.

3. The method of claim 2,
**characterized in that**
the Young's modulus of the material of the stabilization layer (1) is at least twice as great as the Young's modulus of the material of the receiving layer (2).

4. The method of one of the previous claims,
**characterized in that**
the receiving layer (2) and the stabilization layer (4) are firmly bonded to one another.

5. The method of one of the previous claims,
**characterized in that**
the receiving layer (2) is produced as a film and the receiving layer (2) is connected to the stabilization layer (1) in order to form the carrier unit.

6. The method of claim 5,
**characterized in that**
the receiving layer (2) is connected to the stabilization layer by an adhesive layer (6) comprising in particular polydimethylsiloxane (PDMS), plasma-activated adhesion or lamination.

7. The method of claim 5 or 6,
**characterized in that**
the receiving layer (2) is surface-structured such that locally definable stresses are produced in the workpiece due to the surface structuring.

8. The method of claims 1-4,
**characterized in that**
the receiving layer (2) is formed by applying a material that is at least temporarily capable of flowing onto the stabilization layer (1) and by solidifying the material.

9. The method of claim 8,
**characterized in that**
the workpiece (4) is brought into contact with the material before the material solidifies, wherein the workpiece (4) is immersed at least partially in the material.

10. The method of claim 9,
**characterized in that**
an immersion depth is controllable, in particular by increasing the normal force exerted by the workpiece (4) upon the carrier unit or by introducing spacers.

11. The method of one of the previous claims,
**characterized in that**
a connection layer (8), in particular a polymer preferably comprising a polydimethylsiloxane (PDMS), is applied to the workpiece (4), wherein the connection layer (8) is arranged to be substantially parallel to the receiving layer (2) and the portions of the connection layer (8) and the receiving layer (2) that are substantially parallel to one another are spaced apart from one another by the workpiece (4) extending in between.

12. The method of claim 11,
**characterized in that**
the connection layer (8) connects an additional workpiece (4) or an additional stabilization layer to the workpiece (11), wherein the connection layer (8) has a thickness in a range of 0.1 mm to 20 mm, in particular in the range of 0.2 mm to 10 mm, and the stabilization layer (1) has a thickness in a range of 0.01 to 2 mm, in particular in the range of 0.02 mm to 1 mm.

13. The method of one of the previous claims,
**characterized in that**
the receiving layer comprises a polymer, wherein when the composite structure consisting of the receiving layer and the workpiece is exposed to an inner and/or outer stress field at least one part of the polymer undergoes at least one glass transition.

14. A system for producing layers of solid material, in particular wafers, the system comprising at least
an exposition device for exposing the workpiece (4) to stresses for separating a layer of solid material and
a carrier unit, wherein the carrier unit comprises a stabilization layer (1) and the stabilization layer (1) is overlapped at least in sections by a receiving layer (2), wherein the receiving layer (2) is formed to hold the layer of solid material, **characterized in that** the stabilization layer (1) is formed at least in sections to have a Young's modulus greater than a Young's modulus of the receiving layer (2).

15. A carrier unit for receiving at least a layer of solid material, in particular for use in a system according to claim 14,
wherein the carrier unit comprises a stabilization layer (1) and
the stabilization layer (1) is overlapped at least in sections by a receiving layer (2), wherein the receiving layer (2) is formed to hold the layer of solid material, and wherein the stabilization layer (1) is formed at least in sections to have a Young's modulus greater than a Young's modulus of the receiving layer (2).

## Revendications

1. Procédé de fabrication de couches de corps solide, en particulier destinées à être utilisées comme wafer, comprenant les étapes suivantes :
le fait de préparer une pièce de fabrication (4) destinée à détacher les couches de corps solide, la pièce de fabrication (4) comprenant au moins une surface exposée,
la fabrication et/ou le fait de préparer une unité support destinée à recevoir au moins une couche de corps solide,
selon lequel l'unité support a une structure multicouche,
selon lequel l'unité support comprend une couche de stabilisation (1) et la couche de stabilisation (1) se superpose au moins par tronçons à une couche de réception (2),
selon lequel la couche de réception (2) est formée de manière à retenir la couche de corps solide,
et selon lequel la couche de stabilisation (1) est formée au moins par tronçons de manière à avoir un module d'élasticité plus grand que le module d'élasticité de la couche de réception (2),
le fait de relier la couche de réception (2) à la surface exposée de la pièce de fabrication (4) de manière à former une structure composite,
le fait d'appliquer un champ de tension interne et/ou externe à la structure composite de manière à ce que la couche de corps solide soit détachée de la pièce de fabrication (4) le long d'un plan qui s'étend à l'intérieur de la pièce de fabrication (4).

2. Procédé selon la revendication 1,
**caractérisé en ce que**
la couche de réception (2) et la couche de stabilisation (1) sont composées de matériaux différents,
selon lequel la couche de réception (2) comprend de préférence un polymère, en particulier un polydiméthylsiloxane (PDMS), et la couche de stabilisation (1) comprend de préférence un métal.

3. Procédé selon la revendication 2,
**caractérisé en ce que**
le module d'élasticité du matériau de la couche de stabilisation (1) est au moins deux fois plus grand que le module d'élasticité du matériau de la couche de réception (2).

4. Procédé selon l'une des revendications précédentes,
**caractérisé en ce que**
la couche de réception (2) et la couche de stabilisation (1) sont reliées l'une à l'autre par combinaison de matière.

5. Procédé selon l'une des revendications précédentes,
**caractérisé en ce que**
la couche de réception (2) est formée comme une feuille et la couche de réception (2) est reliée à la couche de stabilisation (1) afin de former l'unité support.

6. Procédé selon la revendication 5,
**caractérisé en ce que**
la couche de réception (2) est reliée à la couche de stabilisation au moyen d'une couche adhésive (8), en particulier comprenant du polydiméthylsiloxane (PDMS), une adhésion activée au plasma ou une stratification.

7. Procédé selon l'une des revendications 5 ou 6,
**caractérisé en ce que**
la couche de réception (2) a une structure de surface de manière à ce que des tensions définissables localement soient créées dans la pièce de fabrication du fait de la structure de surface.

8. Procédé selon l'une des revendications 1 à 4,
**caractérisé en ce que**
la couche de réception (2) est formée en appliquant un matériau capable de couler au moins temporairement sur la couche de stabilisation (1) et en durcissant le matériau.

9. Procédé selon la revendication 8,
**caractérisé en ce que**
la pièce de fabrication (4) est mise en contact avec le matériau avant le durcissement du matériau, selon lequel la pièce de fabrication (4) s'immerge au moins par tronçons dans le matériau.

10. Procédé selon la revendication 9,
**caractérisé en ce que**
la profondeur d'immersion est réglable, en particulier via une augmentation de la force normale exercée par la pièce de fabrication (4) sur l'unité support ou en apportant des entretoises.

11. Procédé selon l'une des revendications précédentes,
**caractérisé en ce que**
une couche de liaison (8), en particulier un polymère comprenant de préférence un polydiméthylsiloxane (PDMS), est appliquée sur la pièce de fabrication (4), selon lequel la couche de liaison (8) est parallèle à la couche de réception (2) et les portions de la couche de liaison (8) et de la couche réception (2) qui sont essentiellement parallèles les unes aux autres sont espacées les unes des autres par la pièce de fabrication (4) qui s'étend entre elles.

12. Procédé selon la revendication 11,
**caractérisé en ce que**
la couche de liaison (8) relie une autre pièce de fabrication (4) ou une autre couche de stabilisation à la pièce de fabrication (11), selon lequel la couche de liaison (8) a une épaisseur dans une plage allant de 0,1 mm à 20 mm, en particulier dans une plage allant de 0,2 mm à 10 mm, et la couche de stabilisation (1) a une épaisseur dans une plage allant de 0,01 mm à 2 mm, en particulier dans une plage allant de 0,02 mm à 1 mm.

13. Procédé selon l'une des revendications précédentes,
**caractérisé en ce que**
la couche de réception comprend un polymère, selon lequel lors de l'application d'un champ de tension interne et/ou externe à la structure composite composée de la couche de réception et de la pièce de fabrication au moins une partie du polymère passe par une transition vitreuse.

14. Dispositif de fabrication de couches de corps solide, en particulier de wafers, comprenant au moins :
un dispositif d'application destiné à appliquer des tensions à une pièce de fabrication (4) afin de séparer une couche de corps solide et
une unité support, selon lequel l'unité support comprend une couche de stabilisation (1) et la couche de stabilisation (1) se superpose au moins par tronçons à une couche de réception (2), selon lequel la couche de réception (2) est formée de manière à retenir la couche de corps solide, **caractérisé en ce que**
la couche de stabilisation (1) est formée au moins par tronçons de manière à avoir un module d'élasticité plus grand que le module d'élasticité de la couche de réception (2).

15. Unité support destinée à recevoir au moins une couche de corps solide, en particulier destinée à être utilisée dans un dispositif selon la revendication 14,
selon laquelle l'unité support comprend une couche de stabilisation (1) et
la couche de stabilisation (1) se superpose au moins par tronçons à une couche de réception (2), selon lequel la couche de réception (2) est formée de manière à retenir la couche de corps solide, et selon laquelle la couche de stabilisation (1) est formée au moins par tronçons de manière à avoir un module d'élasticité plus grand que le module d'élasticité de la couche de réception (2).
